# EUROPÄISCHE PATENTSCHRIFT

(11) **EP 0 257 302 B1**
(45) Veröffentlichungstag und Bekanntmachung des Hinweises auf die Patenterteilung: **08.12.1993**
(21) Anmeldenummer: 87110585.4
(22) Anmeldetag: 22.07.1987
(51) Int. Cl.: H01L 21/205, C23C 16/44

(54) **Verfahren zur Erzeugung amorpher Schichten**
Method of producing amorphous layers
Procédé de fabrication de couches amorphes

(30) Priorität: 21.08.1986 DE 3628443
(43) Veröffentlichungstag der Anmeldung: 02.03.1988
(73) Patentinhaber: DORNIER GMBH, D-88004 Friedrichshafen (DE)
(72) Erfinder: Steinwandel, Jürgen, Dr., D-7778 Markdorf (DE); Hauser, Manfred, Prof. Dr., D-7250 Leonberg (DE); Höschele, Jörg, D-7000 Stuttgart (DE)
(74) Vertreter: Landsmann, Ralf, Dipl.-Ing.

(56) Entgegenhaltungen:
- DE-A- 2 631 881
- DE-A- 3 416 470
- PATENT ABSTRACTS OF JAPAN, Band 9, Nr. 49 (E-300)[1772], 2. März 1985;& JP-A-59 189 684
- PATENT ABSTRACTS OF JAPAN, Band 9, Nr. 66 (C-271)[1789], 26. März 1985;& JP-A-59 200 753
- PATENT ABSTRACTS OF JAPAN, Band 10, Nr. 178 (C-355)[2234], 21. Juni 1986;& JP-A-61 26 772
- FIFTH E.C. PHOTOVOLTAIC SOLAR ENERGY CONFERENCE, Athens, 17. - 21. Oktober 1983, Seiten 778-782, D. Reidel Publishing Co., Dordrecht, NL; R. MARTINS et al.: "Analysis of a new production technique for amorphous silicon solar cells"

## Beschreibung

Die Erfindung betrifft ein Verfahren zur Herstellung von Schichten, insbesondere von amorphen Halbleiterschichten, nach dem Oberbegriff des Anspruchs 1.

In der Mikroelektronik werden weitverbreitet Halbleiterbauteile verwendet. Dabei gewinnen derzeit amorphe α-Si:H-Schichten zunehmend an Bedeutung, da daran gearbeitet wird, die teuren Einkristall-Si-Scheiben durch amorphe Schichten zu ersetzen.
Gleiches gilt auch für andere amorphe Halbleiter, beispielsweise α-Ge:H; α-B:H und gegebenenfalls amorphen Kohlenstoff. Es bedeutet dabei beispielsweise α-Si:H = amorphes, wasserstoffdotiertes Silizium.

Folgende Verfahren zur Erzeugung von Halbleiterschichten sind bekannt:
1) Aufdampfen
2) Kathodenzerstäubung (Sputtering)
3) Molekularstrahlepitaxie
4) Thermische Zersetzung gasförmiger Verbindung des Halbleiters und anschliessender Niederschlag auf dem Substrat in einer Reaktionskammer (CVD bzw. Photo-CVD)
5) Zersetzung in einer Glimmentladung.

Das Aufdampfen eignet sich nur zur Herstellung reiner α-Halbleiter-Schichten. Die angestrebten α-Halbleiter:H-Schichten, die durch reaktives Sputtering mit H₂-Trägergasgemischen erzeugt werden, sind derzeit noch in ihren elektronischen Eigenschaften minderwertig.
Bessere Qualitäten ergibt das Verfahren der Molekularstrahlepitaxie, wobei aber in Zukunft, selbst bei denkbaren Verfahrensmodifikationen, eine industrielle Anwendung nicht in Frage kommt, da die erreichbaren Abscheideraten indiskutabel niedrig sind. Zusätzlich ist ein sehr leistungsfähiges differentielles Vakuumpumpensystem erforderlich, das einen Enddruck von ca. 1,32 · 10⁻⁸ Hektopascal zu erzeugen hat.

Dahingegen liefern die Verfahren unter 4 und 5 bei entsprechend temperierten Substraten ohne weitere Modifikationen und Nachbehandlungen die erwünschten Schichten, jedoch mit einer Abscheiderate von nur 1 µm/h. Der Niederschlag dieser Schichten erfolgt unkontrolliert überall im Reaktionsraum. Die Haftung der Schichten auf dem vortemperierten Substrat ist teilweise ungenügend und für die Verwendung der erzeugten Bauteile als Dünnschichttransistoren ungeeignet.
CVD ("chemical vapour deposition") bedeutet eine Gasabscheidung, die durch rein thermische Prozesse eingeleitet wird.
Bei der Photo-CVD geschieht die Einleitung der Dissoziation entweder durch IR-Laseranregung, beispielsweise durch einen CO₂-Laser, oder durch elektronische Laseranregung, beispielsweise durch einen Excimer-Laser.

Ein Verfahren mit Zersetzung in einer Glimmentladung ist aus Patent Abstracts of Japan, Band 9, Nr. 66 (C-271), [1789], 26. März 1985 bekannt. Die neutralen Teilchen eines in der Glimmentladung erzeugten Gases werden durch ein feines Loch in eine Vakuumkammer gesaugt, in der das zu beschichtende Substrat ist. Durch geeignete Maßnahmen wird verhindert, daß Ionen und Elektronen ebenfalls auf das Substrat gelangen.

Aus dem Patent Abstracts of Japan, Band 9, Nr. 49 (E-300), [1772], 02. März 1985 ist ein Beschichtungsverfahren bekannt, bei dem ionisierte Cluster in einem stationären elektrischen Feld auf ein Target beschleunigt werden. Der Beschleunigungsmechanismus beruht hier auf elektrischen Kräften, nicht auf mechanischen Stößen.

Aus der DE 34 16 470 A1 ist ein Verfahren zur Herstellung von Halbleiterschichten auf Trägern bekannt, wobei eine in einem Gasgemisch enthaltene Ausgangsverbindung einem Zerfallprozess ausgesetzt wird und die Zerfallsprodukte mit dem Trägergas durch eine Düse in ein Vakuum auf ein dort angebrachtes Trägerobjekt geleitet werden. Dieses Verfahren bildet den Oberbegriff des Anspruchs 1. Clusterbildungen oder besondere Beschleunigung der Gasteilchen sind weder beschrieben noch erwünscht.

Der Erfindung liegt die Aufgabe zugrunde, ein solches Verfahren dahingehend zu verbessern, daß eine wesentliche Erhöhung der Abscheiderate erzielt wird.

Die Aufgabe wird durch das Verfahren nach Hauptanspruch und Unteransprüchen gelöst.

Die vorliegende Erfindung ermöglicht als einen Anwendungsfall, das kontrollierte Auftragen von amorphen, wasserstoffhaltigen Halbleiterschichten, wie sie bei Halbleiterbauelementen Verwendung finden. Dabei gelingt es durch erfindungsgemäßes Verfahren, die Schichten so herzustellen, daß sie fest am Substrat anhaften und in Dicke und Verteilung so gestaltet sind, dass sie nicht nur eine lose Pulverschicht darstellen. Gegenüber herkömmlichen Verfahren läßt sich eine deutliche Steigerung der Abscheiderate erzielen, wodurch Effizienz und Kostengesichtspunkte verbessert werden können.

Das Verfahren ermöglicht weiterhin die Herstellung von 3/5-Verbindungshalbleitern, wobei die erforderlichen Komponenten gasförmig zugegeben werden, beispielsweise Ga(CH₃)₃ und AsH₃ für GaAs-Halbleiter. In entsprechender Weise können die Halbleitermaterialien direkt positiv oder negativ dotiert werden und gegebenenfalls in Form von p-n- bzw. p-n-p-Übergängen hergestellt werden. Ebenso lassen sich auch keramische Schichten, beispielsweise Si₃N₄ aus den Basisverbindungen SiH₄ und NH₃, sowie amorphe Metalle, beispielsweise Eisen oder Nickel aus den Carbonyl- bzw. Organylbasisverbindungen, herstellen. Weiterhin besteht die Möglichkeit, magnetische Werkstoffe, beispielsweise Fe/Nd/B, aus entsprechenden flüchtigen Elementenverbindungen zu bilden.

Die Schichtzusammensetzung und der Materialauftrag werden während des Auftragsvorganges kontrolliert. Dazu wird der Materialauftrag auf dem Trägerobjekt im Vakuum meßtechnisch erfasst und bildet eine Vergleichsmeßgröße zu einem vorher festgelegten und vorwählbaren Materialauftrag. Die Meßgröße wird in einen elektronischen Steuerkreis eingespeist, der den Materialauftrag durch variable Ventileinstellungen beeinflusst.

Die Erfindung wird anhand von Figuren näher erläutert.

Es zeigen:
- Figur 1: eine schematische Darstellung der Versuchanordnung für plasmainduzierten Zerfall,
- Figur 2: eine Düse mit Freistrahlexpansion,
- Figur 3: eine Düse mit kontrollierter Düsenexpansion,
- Figur 4: eine Darstellung der Expansion im Vakuum.

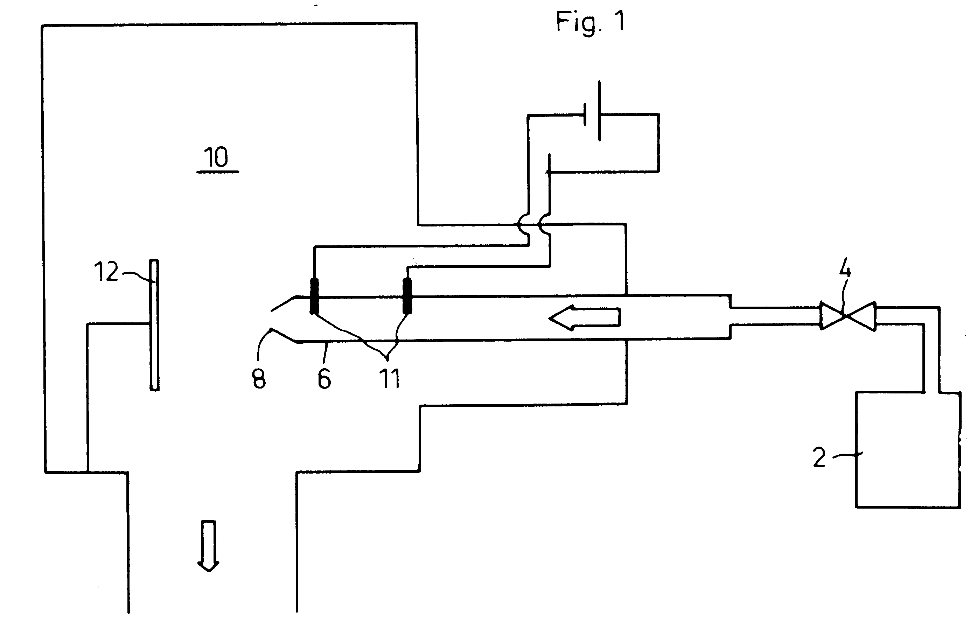

In Figur 1 wird in einem Vorratsbehälter 2 ein Gasgemisch bereitgestellt, das Verbindungen der Elemente enthält aus denen die herzustellende Schicht bestehen soll, beispielsweise ein Gemisch aus 99 % Wasserstoff und 1 % SiH₄, wobei Wasserstoff als Trägergas fungiert. Als Trägergase können weiterhin auch Helium und Argon verwendet werden, wobei die höchste Effizienz des Verfahrens mit dem Element mit der geringsten relativen Atommasse zu erreichen ist, weshalb Wasserstoff (H₂) als Trägergas vorzugsweise einzusetzen ist. Das Gemisch wird über ein Ventil 4 in eine Düse 6 gefördert, und zwar über Unterdruck. Der Druck in der Düse 6 beträgt ca. 1 bis 100 · 1,32 Hektopascal. Hinter der Düsenöffnung 8 befindet sich ein Vakuumraum 10 mit einem Druck kleiner als 0.1 · 1,32 Hektopascal. In dem Vakuumraum 10 ist vor der Düsenöffnung 8 ein Target 12, auf das die zu erzeugende Schicht aufgetragen wird, so befestigt, dass es sich im Bereich der Freistrahlexpansion zwischen Düsenöffnung 8 und Mach'scher Scheibe befindet. Die Mach'sche Scheibe ist eine imaginäre Fläche hinter einer Düse bis zu der die Strömungsteilchen in ein Vakuum gleichförmig expandieren. Die Absaugleistung der Vakuumpumpe ist dabei von großer Bedeutung. Je geringer der verbleibende Druck im Vakuumraum 10, desto größer die Effizienz des Verfahrens. Die Zündung des Plasmas erfolgt hier beispielsweise mittels eines Elektrodenpaars 11.

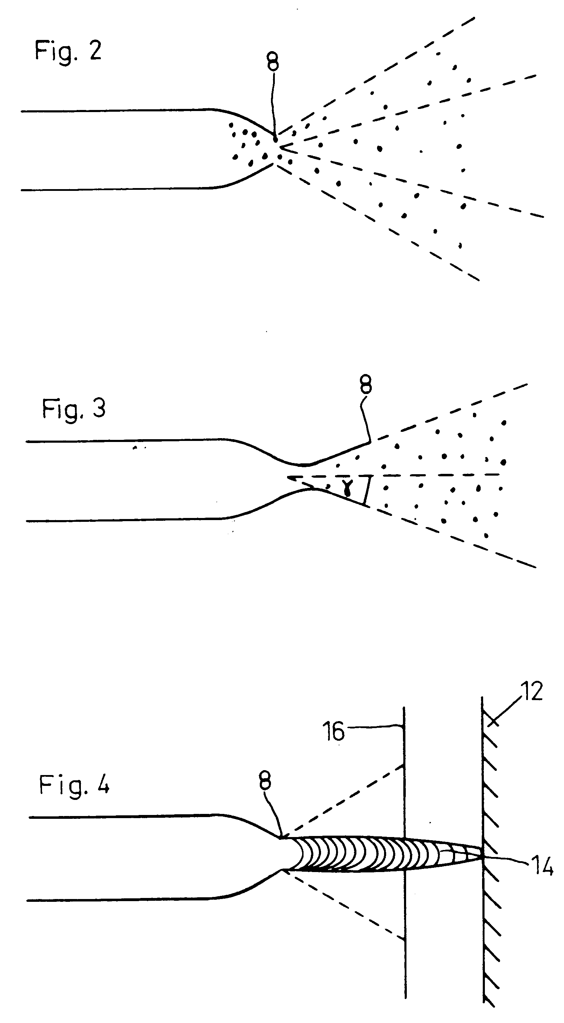

Figur 2 zeigt eine vergrößerte Darstellung der Düse mit Freistrahlexpansion. Vor, in oder hinter der Düsenöffnung 8 wird ein Zerfall der Ausgangsverbindung eingeleitet, unimolekularer Zerfall bei Einstoffsystemen, höhermolekulare Reaktionen bei Mehrstoffsystemen. Der Zerfall im strömenden Gas kann beispielsweise plasmachemisch eingeleitet werden durch Glimmentladungen, HF/RF-Entladungen, thermische Bogenplasmen oder thermisch mittels Widerstands- oder Induktionsheizung, photochemisch mittels CO₂- oder Excimer-Laser oder mittels einer Funkenstrecke. Dabei zerfällt SiH₄ in SiH₂, SiH, Si, Si₂ und H, wobei Teile auch als SiH₄ erhalten bleiben. Die entstehenden wasserstoffhaltigen kondensierbaren Moleküle bewirken eine relative Dampfübersättigung, die eine Gasphasenclusterbildung zur Folge hat. Mikrocluster sind Verbände von einigen zehn bis hundert Atomen oder Molekülen. Die Clusterbildung erfolgt in einem Zeitraum von etwa 10⁻⁶ sec nach dem Zerfall. Wasserstoff dient weiterhin als Trägergas für die Cluster, die sich beschleunigt auf auf die Düsenöffnung 8 zubewegen und an der Öffnung Schallgeschwindigkeit erreicht haben (M=1, mit M=Machzahl=Strömungsgeschwindigkeit/Schallgeschwindigkeit). Wird ein anderes Trägergas als Wasserstoff verwendet, so unterstützt der beim Zerfall entstehende Wasserstoff noch die Trägerfunktion des anderen Gases. Die mittlere gaskinetische Geschwindigkeit ist proportional der Wurzel aus der reziproken Masse (v ∼ √1̅/̅m̅). Die relative Masse der Wasserstoffmoleküle (ca. 2 amu) ist sehr viel kleiner als die relative Masse der Cluster, die bei ca. 300 bis 1000 amu liegt. Da aber der prozentuale Anteil der Cluster im Wasserstoff sehr gering ist, stoßen die Wasserstoffmoleküle die Cluster dauernd an und geben ihren Impuls an die Cluster ab. Dadurch nähert sich die mittlere thermische Geschwindigkeit der Cluster dem Wert der Wasserstoffmoleküle, was zur Folge hat, daß die Cluster sehr große kinetische Überschußenergien bekommen. Hinter der Düsenöffnung 8 wird die Impulsübertragung fortgesetzt und Cluster und Wasserstoff gelangen in der Expansion auf Überschallgeschwindigkeiten, wobei die Cluster etwa 80 bis 90 % der Wasserstoffmolekülgeschwindigkeit annehmen.

Figur 3 zeigt eine Düse mit kontrollierter Düsenexpansion. Hierbei läßt sich über den Öffnungswinkel γ die Expansionsgeschwindigkeit kontrollieren, die Machzahl M ist proportional zum Öffnungwinkel γ (M ∼ γ). Je größer dabei der Winkel γ gestaltet ist, desto größer ist die Machzahl und somit die Austrittsgeschwindigkeit und die kinetische Energie der ausströmenden Teilchen.

Figur 4 zeigt die Expansion der Teilchen ins Vakuum. Dabei koppeln sich die Cluster nicht an die expandierende Strömung an, sondern bleiben aufgrund ihres Translationsüberschusses im Zentrum des Stroms 14. Durch ihre hohe relative Masse lassen sich die Cluster nicht leicht aus ihrer Bahn bringen. Im Expansionsstrahl ist das zu beschichtende Target 12 angeordnet. Das Target 12 muß dabei nicht beheizt sein, aber bei einer Beheizung läßt sich über die Temperaturveränderung noch eine Beeinflussung der Schichtbildung vornehmen. Durch die Überschallexpansion auf das Target 12 als ruhendes Objekt entsteht vor dem Target eine Stosswelle 16. Die auf diese Stosswelle auftreffenden Wasserstoffmoleküle werden dabei auf nahezu Stillstand abgebremst und verlieren ihre kinetische Energie. Hinter der Stosswelle entsteht ein ruhendes Gas. Die Cluster jedoch treten aufgrund ihres großen Impulsüberschusses durch die Stosswelle hindurch und werden dabei aufgeheizt, nachdem sie sich auf dem Weg zwischen Clusterbildung und Stosswelle abgekühlt haben, so dass sie annähernd die gleiche Temperatur erreichen wie vor dem Düsendurchtritt. Dann treffen die Cluster mit einem hohen Impulsüberschuß auf das Target auf und zerplatzen dort zu einer amorphen, sehr gut haftenden Schicht (Impuls-Impaktions-Effekt). Es muß dabei darauf geachtet werden, dass nicht zuviel Material auftrifft, damit kontrollierte Schichten entstehen und kein Pulver. Eine Beeinflussung der Materialauftragung kann durch Veränderung der Strömungsgschwindigkeit, der Konzentration des Anfangsgemisches, der Plasmaenergie und der Vakuumpumpenleistung vorgenommen werden.

Mit dem beschriebenen Verfahren lassen sich Schichten mit ausgezeichneter mechanischer Haftung auf dem Substrat herstellen. Dabei ermöglicht das gezielte Aufbringen der Zerfallprodukte eine hohe Materialausbeute. Die Abscheiderate wird von 1 µm/h auf über 10 µm/h gesteigert. Damit lassen sich beispielsweise Feldeffekttransistoren (FET) in wenigen Minuten herstellen. Bei Verwendung von Schlitzdüsen, eventuell mehrerer parallel betriebener Düsen, und gleichförmig vor der Düse bewegtem Substrat läßt sich eine praktisch unbegrenzte Flächenausdehnung der Schichten erreichen. Ein weiterer wesentlicher Faktor ist die mit der Erfindung verbundene Kostensenkung. Der geringere benötigte Materialaufwand und die verkürzten Fertigungszeiten bringen eine wesentliche Ersparnis. Bei der Herstellung von Feldeffekttransistoren wird gegenüber herkömmlichen Methoden bereits eine Schaltverhältnisverbesserung um den Faktor 10 erreicht.

Neben der Erzeugung von amorphen Halbleiterschichten läßt sich das Verfahren auch zur Herstellung von metall-keramischen Schichten und Gläsern verwenden. Grundsätzlich sind Schichten herstellbar aus Materialien, von denen gasförmige Verbindungen existieren oder ausreichende Konzentrationen durch Sublimations- bzw. Verdampfungsprozesse aus festen bzw. flüssigen Verbindungen hergestellt werden können. Durch die Möglichkeit der über die Gasphase kontrollierbaren Multielementzusammensetzung der Schichten lassen sich 3/5-Verbindungshalbleiter sowie n- bzw. p-dotierte Halbleiterschichten direkt und nacheinander erzeugen. Neben der reinen Halbleiteranwendung ist das Verfahren auch zur Herstellung mehrkomponentiger magnetischer Werkstoffe und amorpher Metallschichten geeignet.

Als Ausführungsbeispiel wird ein Strömungsreaktor beschrieben von 1 cm Durchmesser und einer ausgezogenen Düse mit einem Lochdurchmesser von 0.8 mm. In den Strömungsreaktor sind Platin-Elektroden zu Erzeugung eines Glimmplasmas eingeschmolzen. Als Gasgemisch wird eine Mischung aus 99 Vol.% He und 1 Vol.% SiH₄ verwandt. Der Arbeitsdruck im Plasmareaktor beträgt bei stationärer Glimmentladung 10 · 1,32 Hektopascal und die Plasmaspannung 2000 V bei einem Plasmastrom von 5 mA. Der Absaugdruck der Pumpen liegt auf der Expansionsseite bei 10⁻² · 1,32 Hektopascal. Als Substrattarget wird eine Mikroskopträgerglasplatte eingesetzt, die außer einer Reinigung der Oberfläche mit Methanol keiner weiteren Behandlung unterzogen wird. Während des Betriebs entsteht eine Schicht aus amorphem, wasserstoffhaltigem Silizium mit einer Abscheiderate von ca. 0.3 µm/min.

Bei den gleichen Betriebsbedingungen der Anlage wird eine entsprechend vorbereitete Platine zur Ansteuerung von Flachbildschirmen mittels α-Si:H-Feldeffekttransistoren als Substrattarget eingesetzt. Die nach dem erfindungsgemäßen Verfahren hergestellten FET's zeichnen sich durch ein um einen Faktor > 10 besseres Schaltverhältnis gegenüber konventionell hergestellten FET's aus.

## Patentansprüche

1. Verfahren zur Herstellung von Schichten, insbesondere von amorphen Halbleiterschichten, auf Trägern, wobei ein Gasgemisch eine Ausgangsverbindung in einem Trägergas enthält, und die Ausgangsverbindung einem Zerfallprozess ausgesetzt wird, und die Zerfallsprodukte mit dem Trägergas durch eine Düse in ein Vakuum auf ein dort angebrachtes Trägerobjekt geleitet werden, **dadurch gekennzeichnet,** daß die Zerfallsprodukte Cluster bilden, und daß der prozentuale Anteil der Cluster im Trägergas sehr gering ist das heißt die Cluster sind aus einem Anteil von ca. 1% der Ausgangsverbindung im Trägergas entstanden, so daß die Cluster durch Stöße mit den Trägergasmolekülen eine hohe kinetische Überschußenergie erhalten, das heißt, ca. 80 bis 90 % der Trägergasmolekülgeschwindigkeit.

2. Verfahren nach Anspruch 1, dadurch gekennzeichnet, dass der Zerfallsprozess im strömenden Gasgemisch durch Plasmaprozesse, thermisch, photochemisch oder mittels einer Funkenstrecke eingeleitet wird.

3. Verfahren nach einem der Ansprüche 1 oder 2, dadurch gekennzeichnet, dass die Clusterbildungsreaktionen vor, in oder hinter der Düse, vorzugsweise vor der Düse, durchgeführt werden.

4. Verfahren nach einem der Ansprüche 1 bis 3, dadurch gekennzeichnet, dass ein Gasgemisch aus flüchtigen Elementverbindungen und H₂ verwendet wird.

5. Verfahren nach einem der Ansprüche 1 bis 3, dadurch gekennzeichnet, dass ein Gasgemisch aus flüchtigen Elementverbindungen und Helium oder Argon verwendet wird.

6. Verfahren nach einem der Ansprüche 4 oder 5, dadurch gekennzeichnet, dass als flüchtige Elementverbindungen SiH₄, GeH₄ oder B₂H₆ verwendet werden.

7. Verfahren nach einem der Ansprüche 1 bis 3, dadurch gekennzeichnet, dass ein Gasgemisch aus mehreren miteinander reaktionsfähigen Elementverbindungen und H₂ verwendet wird.

8. Verfahren nach einem der Ansprüche 1 bis 3, dadurch gekennzeichnet, dass ein Gasgemisch aus mehreren miteinander reaktionsfähigen Elementverbindungen und Helium oder Argon verwendet wird.

9. Verfahren nach einem der Ansprüche 7 oder 8, dadurch gekennzeichnet, dass als reaktionsfähige Elementverbindung Ga(CH₃)₃/AsH₃ zur Herstellung von 3/5-Verbindungshalbleitern verwendet wird.

10. Verfahren nach einem der Ansprüche 7 oder 8, dadurch gekennzeichnet, dass als reaktionsfähige Elementverbindung SiH₄/NH₃ zur Herstellung keramischer Schichten verwendet wird.

11. Verfahren nach einem der Ansprüche 1 bis 10, dadurch gekennzeichnet, dass die Teilchen hinter der Düsenöffnung einer Freistrahlexpansion ausgesetzt werden.

12. Verfahren nach einem der Ansprüche 1 bis 10, dadurch gekennzeichnet, dass die Teilchen hinter der Düsenöffnung einer kontrollierten Düsenexpansion ausgesetzt werden.

13. Verfahren nach einem der Ansprüche 1 bis 12, dadurch gekennzeichnet, dass eine Düse mit zweidimensionaler Strömungsgeometrie (Schlitzdüse) verwendet wird.

14. Verfahren nach einem der Ansprüche 1 bis 12, dadurch gekennzeichnet, dass eine Düse mit dreidimensionaler Strömungsgeometrie (Runddüse) verwendet wird.

15. Verfahren nach einem der Ansprüche 1 bis 14, dadurch gekennzeichnet, dass mehrere Düsen parallel eingesetzt werden.

16. Verfahren nach einem der Ansprüche 1 bis 15, dadurch gekennzeichnet, dass der Materialauftrag auf das Trägerobjekt meßtechnisch erfasst wird und diese Meßgröße in einen elektronischen Ventilsteuerkreis eingespeist wird, durch den ein vorwählbarer Materialauftrag kontrolliert wird.

17. Verfahren nach einem der Ansprüche 1 bis 16, dadurch gekennzeichnet, dass der Materialauftrag durch Strömungsgeschwindigkeit des Gasgemisches, Konzentration des Gasgemisches, Höhe der primären Anregungsenergie und Höhe der Vakuumpumpenleistung beeinflusst wird.

18. Verfahren nach einem der Ansprüche 1 bis 17, dadurch gekennzeichnet, dass ca. 99 % des Gasgemisches als Trägergas benutzt werden.

19. Verfahren nach einem der Ansprüche 1 bis 18, dadurch gekennzeichnet, dass der Druck im Vakuumgefäß kleiner als 1.32 hPa (0.1 Torr) eingestellt werden kann.

## Claims

1. Method of producing layers, in particular amorphous semiconductor layers, on carriers, wherein a gas mixture contains an initial compound in a carrier gas, and the initial compound is subjected to a disintegration process, and the products of disintegration are conducted with the carrier gas through a nozzle into a vacuum to a carrier object mounted there, characterised in that the products of disintegration form clusters, and in that the percentage of clusters in the carrier gas is very small, i.e. the clusters result from a content of approximately 1% of the initial compound in the carrier gas, such that the clusters receive high kinetic excess energy, i.e. approximately 80 to 90% of the carrier gas molecular speed, as a result of impact with the carrier gas molecules.

2. Method according to Claim 1, characterised in that the disintegration process is initiated in the flowing gas mixture by plasma processes, or thermally, photochemically or by means of a spark gap.

3. Method according to either of Claims 1 and 2, characterised in that the cluster formation reactions are performed in front of, in or behind the nozzle, and preferably in front of the nozzle.

4. Method according to any one of Claims 1 to 3, characterised in that a gas mixture consisting of volatile component compounds and H₂ is used.

5. Method according to any one of Claims 1 to 3, characterised in that a gas mixture consisting of volatile component compounds and helium or argon is used.

6. Method according to either of Claims 4 or 5, characterised in that SiH₄, GeH₄ or B₂H₆ are used as volatile component compounds.

7. Method according to any one of Claims 1 to 3, characterised in that a gas mixture consisting of a plurality of component compounds, which can react with one another, and H₂ is used.

8. Method according to any one of Claims 1 to 3, characterised in that a gas mixture consisting of a plurality of component compounds, which can react with one another, and helium or argon is used.

9. Method according to either of Claims 7 and 8, characterised in that Ga(CH₃)₃ / AsH₃ is used as a reactive component compound for producing 3/5 compound semiconductors.

10. Method according to either of Claims 7 and 8, characterised in that SiH₄ / NH₃ is used as a reactive component compound for producing ceramic layers.

11. Method according to any one of Claims 1 to 10, characterised in that the particles are subjected to free jet expansion behind the nozzle opening.

12. Method according to any one of Claims 1 to 10, characterised in that the particles are subjected to controlled nozzle expansion behind the nozzle opening.

13. Method according to any one of Claims 1 to 12, characterised in that a nozzle with two-dimensional flow geometry (slotted nozzle) is used.

14. Method according to any one of Claims 1 to 12, characterised in that a nozzle with three-dimensional flow geometry (circular nozzle) is used.

15. Method according to any one of Claims 1 to 14, characterised in that a plurality of nozzles is used in parallel.

16. Method according to any one of Claims 1 to 15, characterised in that the material deposited on the carrier object is determined according to measuring technology and this measuring value is fed into an electronic valve control circuit which controls a pre-selectable material deposition process.

17. Method according to any one of Claims 1 to 16, characterised in that the deposition of material is influenced by the flow speed of the gas mixture, the concentration of the gas mixture, the level of primary energizing energy and the level of the vacuum pump delivery.

18. Method according to any one of Claims 1 to 17, characterized in that approximately 99% of the gas mixture is used as carrier gas.

19. Method according to any one of Claims 1 to 18, characterised in that the pressure inside the vacuum chamber can be adjusted to less than 1.32 hPa (1.32mm Hg pressure).

## Revendications

1. Procédé de fabrication de couches, en particulier de couches amorphes semi-conductrices, sur des supports, un mélange gazeux comprenant un composé de départ dans un gaz porteur, le composé de départ étant soumis à un processus de décomposition et les produits de décomposition étant envoyés conjointement avec le gaz porteur au travers d'une buse sur un objet-support disposé dans un vide, **caractérisé en ce** que les produits de décomposition forment des agglomérats de molécules et que le pourcentage des agglomérats de molécules dans le gaz porteur est très faible, c'est-à-dire que les agglomérats de molécules ont été formés à partir d'une proportion d'environ 1 % du composé de départ dans le gaz porteur, de sorte que les agglomérats de molécules reçoivent par des collisions avec les molécules du gaz porteur, une haute énergie cinétique excédentaire, c'est-à-dire environ 80 à 90 % de la vitesse des molécules du gaz porteur.

2. Procédé selon la revendication 1, caractérisé en ce que le processus de décomposition est déclenché dans le mélange gazeux en circulation par des processus plasmatiques, thermiques, photochimiques ou au moyen d'un éclateur.

3. Procédé selon l'une des revendications 1 ou 2, caractérisé en ce que les réactions de formation d'agglomérats de molécules se déroulent en avant, dans ou en arrière de la buse, de préférence en avant de la buse.

4. Procédé selon l'une des revendications 1 à 3, caractérisé en ce qu'il met en oeuvre un mélange gazeux constitué de composés volatils et de H₂.

5. Procédé selon l'une des revendications 1 à 3, caractérisé en ce qu'il met en oeuvre un mélange gazeux constitué de composés volatils et d'hélium ou d'argon.

6. Procédé selon l'une des revendications 4 ou 5, caractérisé en ce qu'il met en oeuvre comme composés volatils du SiH₄, du GeH₄ ou du B₂ H₆.

7. Procédé selon l'une des revendications 1 à 3, caractérisé en ce qu'il met en oeuvre un mélange gazeux constitué de plusieurs **composés** capables de réagir les uns avec les autres et de H₂.

8. Procédé selon l'une des revendications 1 à 3, caractérisé en ce qu'il met en oeuvre un mélange gazeux constitué de plusieurs **composés** capables de réagir les uns avec les autres et d'hélium ou d'argon.

9. Procédé selon l'une des revendications 7 ou 8, caractérisé en ce qu'il met en oeuvre comme composé réactif Ga(CH₃)₃/AsH₃ pour la fabrication de semi-conducteurs de combinaison 3/5.

10. Procédé selon l'une des revendications 7 ou 8, caractérisé en ce qu'il met en oeuvre comme composé réactif SiH₄/NH₃ pour la fabrication de couches céramiques.

11. Procédé selon l'une des revendications 1 à 10, caractérisé en ce que les particules sont soumises en aval de la sortie de buse à une expansion à jet libre.

12. Procédé selon l'une des revendications 1 à 10, caractérisé en ce que les particules sont soumises en aval de la sortie de buse à une expansion à buses contrôlée.

13. Procédé selon l'une des revendications 1 à 12, caractérisé en ce qu'il utilise une buse à géométrie d'écoulement bidimensionnelle (buse plate).

14. Procédé selon l'une des revendications 1 à 12, caractérisé en ce qu'il utilise une buse à géométrie d'écoulement tridimensionnelle (buse circulaire).

15. Procédé selon l'une des revendications 1 à 14, caractérisé en ce qu'il utilise plusieurs buses en parallèle.

16. Procédé selon l'une des revendications 1 à 15, caractérisé en ce que l'application de matière sur l'objet-support est détectée métrologiquement et que cette grandeur de mesure est injectée dans un circuit de commande électronique de soupapes qui contrôle une application de matière pouvant être présélectionnée.

17. Procédé selon l'une des revendications 1 à 16, caractérisé en ce que l'application de matière est modifiée par la vitesse d'écoulement du mélange gazeux, la concentration du mélange gazeux, la valeur de l'énergie d'excitation primaire et la valeur du débit de la pompe à vide.

18. Procédé selon l'une des revendications 1 à 17, caractérisé en ce qu'environ 99 % du mélange gazeux sont utilisés comme gaz porteur.

19. Procédé selon l'une des revendications 1 à 18, caractérisé en ce que la pression dans le récipient à vide peut être réglée à une valeur inférieure à 1,32 hPa (0,1 Torr).
